# EUROPÄISCHE PATENTANMELDUNG

(11) **EP 1 666 631 A2**
(43) Veröffentlichungstag der Anmeldung: **07.06.2006**
(21) Anmeldenummer: 05024381.5
(22) Anmeldetag: 09.11.2005
(51) Int. Cl.: C23C 14/34

(54) **Rohrförmiges Sputtertarget**

(30) Priorität: 02.12.2004 DE 102004058316
(71) Anmelder: W.C. Heraeus GmbH, 63450 Hanau (DE)
(72) Erfinder: Weigert, Martin, 63457 Hanau (DE); Schultheis, Markus, 36103 Flieden (DE); Schlott, Martin, 63075 Offenbach (DE); Simons, Christoph, 63599 Biebergemünd (DE)
(74) Vertreter: Kühn, Hans-Christian

(57) **Zusammenfassung**

Die Erfindung betrifft ein rohrförmiges Sputtertarget mit einem Targetkörper und mit an mindestens einem Rohrende angeordneter Befestigungsvorrichtung und besteht darin, dass die Befestigungsvorrichtung und/oder ein Rohrenddeckel stoffschlüssig oder formschlüssig mit dem Targetkörper verbunden sind.

## Beschreibung

Die Erfindung betrifft ein rohrförmiges Sputtertarget mit einem Targetkörper und mit an mindestens einem Rohrende angeordneter Befestigungsvorrichtung.

Derartige Sputtertargets sind zahlreich bekannt, beispielsweise aus WO 97/15697 oder aus DE 100 43 748 oder DE 100 63 383. Derartige rohrförmige Sputtertargets können entweder selbsttragend aus dem abzusputternden Material oder aus einer Beschichtung des abzusputternden Materials auf einem Trägerrohr gebildet sein.

In der Praxis gewinnen dünne Schichten aus Molybdän oder Molybdänlegierungen für optische Funktionsschichten zunehmend an Bedeutung, insbesondere in der großflächigen Glasbeschichtung und bei der Beschichtung von Flachbildschirmen. Derartige Beschichtungen werden in der Regel durch Sputtern hergestellt, wobei zunehmend rohrförmige Targets eingesetzt werden, da diese eine bessere Ausbeute und ein gleichmäßiges Sputterergebnis ermöglichen. Gerade auch Molybdän oder Molybdänlegierungen (insbesondere Molybdän-Basislegierungen) werden hier eingesetzt. Sie werden als Sputtertargetmaterial auf Trägerrohre aufgebracht und auf diesen angelötet, um eine ausreichende Stabilität der rohrförmigen Sputtertargets zu erreichen. Diese Konstruktionen, bei denen üblicherweise Edelstahl als Trägerrohrmaterial verwendet wird, weisen eine begrenzte Fähigkeit zur Wärmeaufnahme und -ableitung auf, da die Lötverbindung häufig den thermischen Belastungen nicht widersteht. Wenn das Lot jedoch aufschmilzt und aus den Randspalten nach außen austritt, ist das Sputtertarget nicht mehr verwendbar.

Das vorstehende Problem wird erfindungsgemäß durch den Gegenstand des Hauptanspruchs gelöst. Vorteilhafte Ausgestaltungen sind in den Unteransprüchen angegeben.

Dadurch, dass die Befestigungsvorrichtung und/oder ein Rohrenddeckel stoffschlüssig oder formschlüssig mit dem Trägerkörper verbunden ist, werden zum einen die sich durch den sonst notwendigen Lötvorgang zwischen Sputtermaterial und Trägerrohr ergebenden Probleme vermieden, zum anderen wird durch die Stabilisierung der Rohrenden die notwendige mechanische Festigkeit und durch die stoffschlüssige oder formschlüssige Verbindung auch die notwendige Vakuumdichtheit erzeugt, insbesondere, wenn der Targetkörper sich nahezu vollständig über den Rohrquerschnitt erstreckt.

Insbesondere ist es vorteilhaft, dass der Targetkörper aus Metall, vorzugsweise aus Titan, Molybdän, Niob, Chrom, Wolfram, Aluminium, Kupfer, Zirkonium, Tantal, Nickel, Silber oder einer Legierung mit mindestens einem dieser Metalle gebildet ist. Desweiteren ist es vorteilhaft, wenn Befestigungsvorrichtung (vorzugsweise als Flansch ausgebildet) und/oder Rohrenddeckel aus Titan, Molybdän, Wolfram, Chrom, Aluminium, Silber, Nickel, Zink, Kupfer, Zirkonium, Vanadium, Niob, Tantal oder einer Legierung mit mindestens einem dieser Metalle gebildet sind, da diese sich zum einen gut mit dem Targetmaterial verbinden lassen und zum anderen die notwendige Stabilität und Wärmeableitung gewährleisten. Insbesondere eignen sich Legierungen von Titan mit einem oder mehreren Metallen der Gruppe Aluminium, Zinn, Kupfer, Zirkonium, Vanadium, Molybdän. Vorzugsweise werden Titan-Aluminium-Zinn-, Titan-Kupfer-, Titan-Aluminium-Zirkonium-, Titan-Aluminium-Vanadium- oder Titan-Aluminium-MolybdänLegierungen verwendet. Das Material des Targetkörpers kann vorzugsweise etwa 0,5 bis etwa 5 Gew.-% Chrom oder Wolfram aufweisen. Zweckmäßig ist es weiterhin, dass Targetkörper und Befestigungsvorrichtung und/oder Rohrenddeckel aus dem gleichen Material gebildet sind. Es ist weiterhin vorteilhaft, dass Befestigungsvorrichtung und/oder Rohrenddeckel an den Targetkörper gelötet oder geschweißt, insbesondere elektronenstrahlgeschweißt sind. Der Targetkörper kann durch Umformen, beispielsweise Strangpressen oder Flowformen eines Ausgangskörpers hergestellt werden.

Derartige Sputtertargets sind energetisch höher belastbar, als die bekannten, oben beschriebenen Trägerrohr-Sputterschicht-Konstruktionen, da sie eine bessere thermische Wärmeleitfähigkeit besitzen. Gegenüber den bekannten Rohren können sie etwa 1,5 mal mehr energetisch belastet werden. Die mit den erfindungsgemäßen Sputtertargets hergestellten Schichten weisen gute Transmissions-, Reflektions- und Schichtwiderstandswerte auf.

In der Anlage wird die Erfindung beispielhaft anhand einer Zeichnung erläutert. In der Zeichnung zeigt
- Figur 1: ein einseitig gelagertes Rohrtarget,
- Figur 2: ein beidseitig gelagertes Rohrtarget.

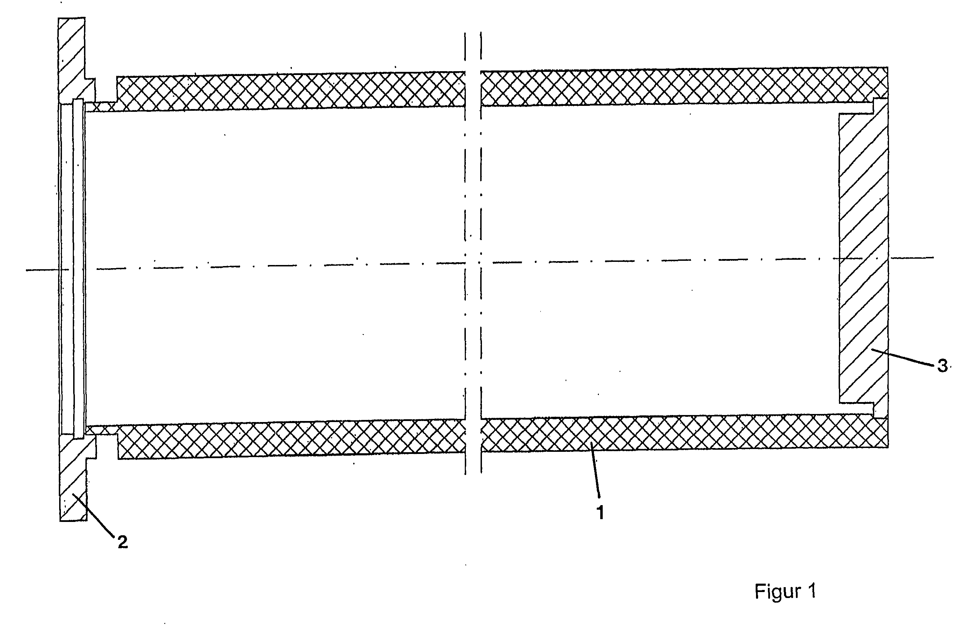

Rohrtargets können in der Sputteranlage entweder einseitig oder zweiseitig gelagert werden. Das Innere des Rohres ist vakuumdicht gegenüber der Umgebung abgeschlossen. Der Targetkörper 1 ist aus Molybdän gebildet, gegebenenfalls mit einem Anteil von etwa 0,5 bis etwa 5 Gew.-% Chrom oder Wolfram. Im Falle von einseitig gelagerten Rohrtargets (Figur 1) wird ein Befestigungsflansch 2 an lediglich einem Ende des Rohres mittels Elektronenstrahlschweißverfahren vakuumdicht angeschweißt, während das andere Ende mit einem Rohrenddeckel 3 vakuumdicht durch Elektronenstrahlschweißen verbunden ist.

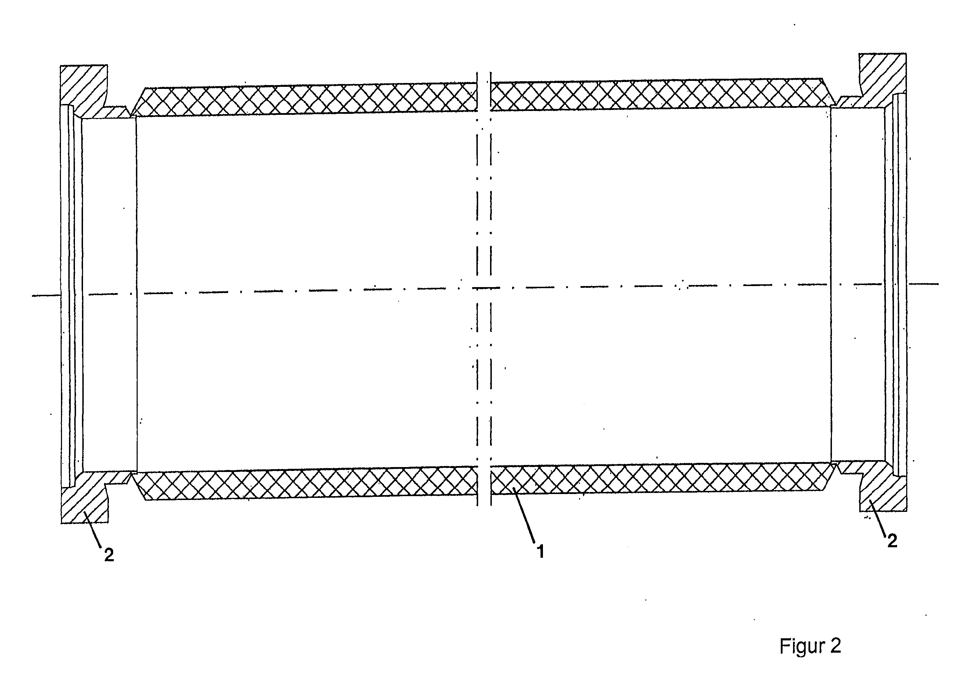

Im Falle einer beidseitigen Lagerung eines Rohrtargets (Figur 2) ist an beiden Enden des Targetkörpers 1 ein Bestigungsflansch 2 angeschweißt. Auch hier ist die Verbindung vakuumdicht und bevorzugt durch Elektronenstrahlschweißverfahren hergestellt. Als Material für den Rohrenddeckel 3 oder den Befestigungsflansch 2 eignen sich insbesondere die oben genannten Titanlegierungen.

Molybdän kann beispielsweise verwendet werden als Sputtermaterial für Rückkontakte in der Photovoltaik (Großflächenbeschichtung) oder als Diffusionsbarriere zwischen Aluminium und Silizium in der Displaybeschichtung. Titan kann beispielsweise verwendet werden zur Bildung von hochbrechenden Titandioxidschichten oder als Diffusionsbarriere. Chrom kann beispielsweise verwendet werden als Reflektor oder CrN-Absorber in der Glasbeschichtung oder in sogenannten Black Matrix Displays. Niob kann beispielsweise in der Glasbeschichtung verwendet werden zur Bildung hochbrechender Nb₂O₅-Schichten. Wolfram als Sputtermaterial findet unter anderem Verwendung als Wolframoxid in der Elektrochromie.

## Patentansprüche

1. Rohrförmiges Sputtertarget mit einem Targetkörper und mit an mindestens einem Rohrende angeordneter Befestigungsvorrichtung, **dadurch gekennzeichnet, dass** die Befestigungsvorrichtung und/oder ein Rohrenddeckel stoffschlüssig oder formschlüssig mit dem Targetkörper verbunden sind.

2. Rohrförmiges Sputtertarget nach Anspruch 1, **dadurch gekennzeichnet, dass** der Targetkörper sich nahezu vollständig über den Rohrquerschnitt erstreckt.

3. Rohrförmiges Sputtertarget nach Anspruch 1 oder 2, **dadurch gekennzeichnet, dass** der Targetkörper aus Metall, vorzugsweise aus Titan, Molybdän, Niob, Chrom, Wolfram, Aluminium, Kupfer, Zirkonium, Tantal, Nickel, Silber oder einer Legierung mit mindestens einem dieser Metalle gebildet ist.

4. Rohrförmiges Sputtertarget nach einem der Ansprüche 1 bis 3, **dadurch gekennzeichnet, dass** Befestigungsvorrichtung und/oder Rohrenddeckel aus Titan, Molybdän, Wolfram, Chrom, Aluminium, Silber, Nickel, Zink, Kupfer, Zirkonium, Vanadium, Niob, Tantal oder einer Legierung mit mindestens einem dieser Metalle gebildet sind.

5. Rohrförmiges Sputtertarget nach Anspruch 4, **dadurch gekennzeichnet, dass** die Titanlegierung aus Titan und einem oder mehreren Metallen der Gruppe Aluminium, Zinn, Kupfer, Zirkonium, Vanadium, Molybdän gebildet ist.

6. Rohrförmiges Sputtertarget nach einem der Ansprüche 1 bis 5, **dadurch gekennzeichnet, dass** Targetkörper und Befestigungsvorrichtung und/oder Rohrenddeckel aus dem gleichen Material gebildet sind.

7. Rohrförmiges Sputtertarget nach einem der Ansprüche 1 bis 6, **dadurch gekennzeichnet, dass** Befestigungsvorrichtung und/oder Rohrenddeckel an den Targetkörper gelötet oder geschweißt, insbesondere elektronenstrahlgeschweißt sind.

8. Rohrförmiges Sputtertarget nach einem der Ansprüche 1 bis 7, **dadurch gekennzeichnet, dass** die Befestigungsvorrichtung als Flansch ausgebildet ist.

9. Rohrförmiges Sputtertarget nach einem der Ansprüche 1 bis 8, **dadurch gekennzeichnet, dass** der Targetkörper etwa 0,5 bis etwa 5 Gew.-% Chrom und/oder Wolfram aufweist.
